(19) Europäisches Patentamt / European Patent Office / Office européen des brevets

(11) **EP 4 693 768 A1**

(12) **EUROPEAN PATENT APPLICATION**
published in accordance with Art. 153(4) EPC

(43) Date of publication:
**11.02.2026 Bulletin 2026/07**

(21) Application number: **24780782.9**

(22) Date of filing: **29.03.2024**

(51) International Patent Classification (IPC):
**H01S 5/02253** (2021.01)     **H01S 5/0239** (2021.01)

(52) Cooperative Patent Classification (CPC):
**H01S 5/02253; H01S 5/0239**

(86) International application number:
**PCT/JP2024/012995**

(87) International publication number:
**WO 2024/204687 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2023 JP 2023054247**

(71) Applicants:
• **NTT, Inc.**
 **Tokyo 100-8116 (JP)**
• **NTT Innovative Devices Corporation**
 **Yokohama-shi, Kanagawa 221-0031 (JP)**

(72) Inventors:
• **NAKANISHI Yasuhiko**
 **Musashino-shi, Tokyo 180-8585 (JP)**

• **KANAZAWA Shigeru**
 **Musashino-shi, Tokyo 180-8585 (JP)**
• **SAHARA Akio**
 **Yokohama-shi, Kanagawa 221-0031 (JP)**
• **KOSUGI Toshihiko**
 **Yokohama-shi, Kanagawa 221-0031 (JP)**
• **NISHIZAWA Toshiki**
 **Kawasaki-shi, Kanagawa 212-8510 (JP)**
• **UCHIDA Toshiaki**
 **Kawasaki-shi, Kanagawa 212-8510 (JP)**
• **OOBA Naoki**
 **Kawasaki-shi, Kanagawa 212-8510 (JP)**
• **MITSUHASHI Yuji**
 **Kawasaki-shi, Kanagawa 212-8510 (JP)**

(74) Representative: **Hoffmann Eitle**
 **Patent- und Rechtsanwälte PartmbB**
 **Arabellastraße 30**
 **81925 München (DE)**

(54) **OPTICAL TRANSMISSION MODULE**

(57)     A light transmitter module (10) includes: a light emitting element (LD) (11) for outputting a laser light; a lens (12) provided in an optical path of the laser light; and a light receiving element (PD) (13) provided downstream of the lens (12) in the optical path of the laser light and for receiving a part of the laser light that has passed through the lens (12).

EP 4 693 768 A1

# FIG. 1

(a)

(b)

**Description**

TECHNICAL FIELD

The present disclosure relates to an optical transmitter module.

BACKGROUND ART

One of the constant challenges for optical communication systems is to improve system throughput. Due to this demand, optical transmitter modules, which are fundamental components of optical communication systems, have been required its miniaturization.

The optical transmitter module includes a laser diode which outputs a laser light for communication. Hereinafter, the laser diode is referred to as LD. The LD used in the optical communication system is required to have a stable optical output. However, the optical power may fluctuate due to temperature variations and aging. In order to suppress this fluctuation, feedback control of the LD is performed by monitoring the optical power using a photodiode. Hereinafter the photodiode is referred to as PD. As a related technology, Patent Literature 1 discloses an optical transmitter module with a built-in PD.

CITATION LIST

PATENT LITERATURE

Patent Literature 1: JP 2004-165299 A

SUMMARY OF INVENTION

TECHNICAL PROBLEM

A laser light output from the LD propagates with a certain divergence angle. To efficiently couple the laser light having such a divergence angle to an optical fiber, it is advantageous to use a lens with a large numerical aperture (NA). However, generally, as the numerical aperture increases, the effective aperture of the lens increases, and the size of the optical transmitter module becomes large. In addition, physical interference with the PD built into the optical transmitter module is also a concern. The enlargement of the optical transmitter module is likely to conflict with the improvement of the system throughput.

The present disclosure has been made in view of the above-mentioned circumstances. An object of the present disclosure is to provide an optical transmitter module capable of being miniaturized while incorporating a PD as an optical monitor.

SOLUTION TO PROBLEM

An optical transmitter module according to an aspect of the present disclosure includes:

ADVANTAGEOUS EFFECTS OF INVENTION

According to the present disclosure, it is possible to provide an optical transmitter module capable of being miniaturized while incorporating a PD as an optical monitor.

BRIEF DESCRIPTION OF DRAWINGS

[FIG. 1] FIG. 1 is a diagram illustrating an example of the configuration of an optical transmitter module according to the embodiment of the present disclosure, wherein (a) is the side view and (b) is the front view.
[FIG. 2] FIG. 2 is an enlarged diagram illustrating an arrangement of the configuration from a laser diode to an optical fiber.
[FIG. 3] FIG. 3 is a diagram illustrating another example of the configuration of the optical transmitter module, wherein (a) is the side view and (b) is the front view.
[FIG. 4] FIG. 4 is a graph showing an example of the relationship between the numerical aperture of the lens and the optical coupling efficiency to the optical fiber.

[FIG. 5] FIG. 5 is a graph showing changes in optical coupling efficiency obtained by numerical analysis.

[FIG. 6] FIG. 6 is a graph showing changes in optical coupling efficiency obtained by numerical analysis.

[FIG. 7] FIG. 7 is an enlarged diagram illustrating the vicinity of the photodiode (PD) illustrated in FIG. 2, wherein (a) is the front view and (b) is the plan view when viewed from the lens side.

[FIG. 8] FIG. 8 is a diagram for explaining the optical path of the laser light incident on the transmission surface.

[FIG. 9] FIG. 9 is a diagram illustrating a mirror image of the PD with a reflective surface of the PD as a symmetrical plane.

[FIG. 10] FIG. 10 is a diagram schematically showing a change in incident efficiency of the laser light to the PD with the movement amount d of the optical axis of the laser light as a parameter.

[FIG. 11] FIG. 11 is a diagram for explaining the optical path of the laser light when the side surface of the PD is a scattering surface.

[FIG. 12] FIG. 12 is a diagram showing a change in incident efficiency when the scattering surface is provided to the PD.

DESCRIPTION OF EMBODIMENTS

The optical transmitter module according to an embodiment of the present disclosure will be described below. It should be noted that the same reference numerals are denoted to common parts in the respective figures, and duplicate descriptions will be omitted.

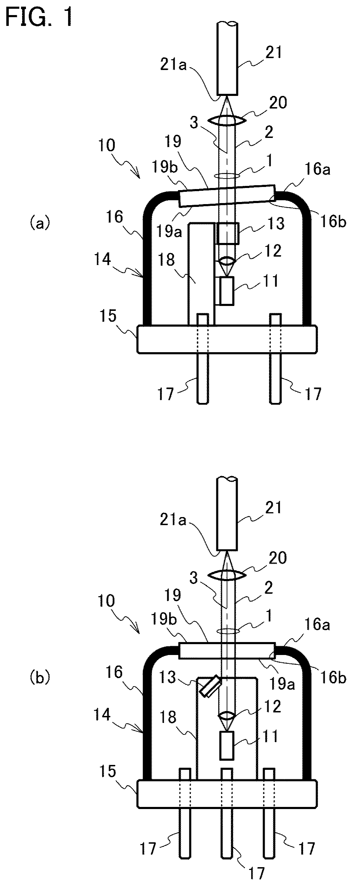

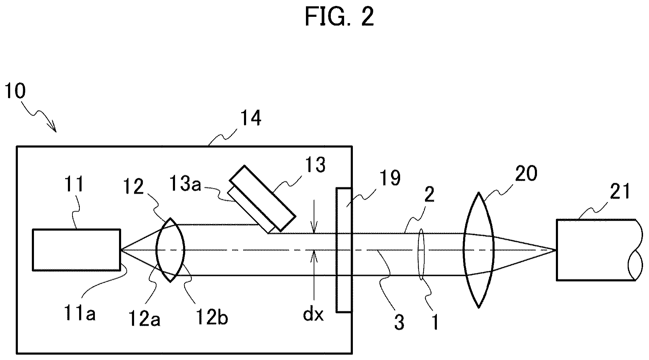

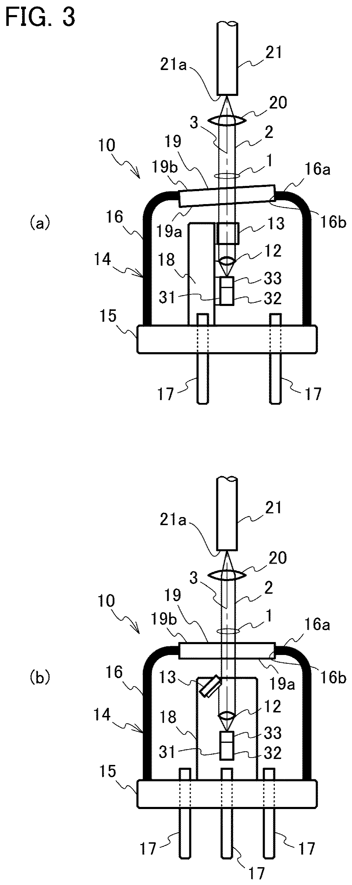

FIG. 1 is a diagram illustrating an example of the configuration of the optical transmitter module 10 according to the present embodiment, wherein (a) is the side view and (b) is the front view. FIG. 2 is an enlarged diagram illustrating the arrangement of the configuration from the laser diode to the optical fiber. FIG. 3 is a diagram illustrating another example of the configuration of the optical transmitter module 10, wherein (a) is the side view and (b) is the front view.

The optical transmitter module 10 is an optical device that converts an input electric signal into an optical signal of the laser light 1 and outputs the optical signal. A laser light 1 output from the optical transmitter module 10 is input to an end 21a of an optical fiber 21 through an optical element such as a condenser lens 20. The optical transmitter module 10 according to the present embodiment is used, for example, as a component of an optical communication system.

The optical transmitter module 10 includes: a laser diode 11 as a light-emitting element, a lens 12, a photodiode 13 as a light-receiving element, and a package 14 that houses them. Hereinafter, for convenience of explanation, the laser diode is referred to as LD and the photodiode is referred to as PD. In addition, a locus of the laser light 1 output from the LD 11 is referred to as an optical path 2, and a central axis of the optical path 2 is referred to as an optical axis 3.

First, the package will be described. The package 14 includes a stem 15 and a cap 16. The stem 15 is formed into a disk shape to support lead pins 17. Each lead pin 17 is electrically connected to the LD 11, the PD 13, or their control circuits (not shown). The stem 15 includes a carrier (a chip carrier and carrier substrate) 18. The LD 11, the lens 12, and the PD 13 are attached to the carrier 18. In other words, the carrier 18 supports them.

The cap 16 is a hollow cylindrical member having a predetermined outer diameter. The cap 16 has an upper surface 16a that covers components on the stem 15 such as the LD 11, the lens 12, the PD 13. The upper surface 16a is formed with a window portion (frame portion) 16b, which is located at a position where the upper surface 16a intersects the optical path 2 of the laser light 1. A transparent plate 19 is attached to the window portion 16b. The transparent plate 19 is a plate member formed of glass material. The transparent plate 19 has an incident surface 19a and an exit surface 19b of the laser light 1. The incident surface 19a and the exit surface 19b may be orthogonal to the optical path 2 of the laser light 1, or may be inclined thereto as shown in FIG. 1(a). In the latter case, the inclination prevents the laser light reflected from the transparent plate 19 (so-called return light) from entering the LD 11.

A space in the cap 16 is sealed by fixing the cap 16 to the stem 15. The package 14 has the shape of a TO-CAN type shown in FIG. 1. The TO-CAN package is a standard package for optical transmitter modules. However, the shape of the package 14 is not limited to the TO-CAN type, and other types of package shapes may be adopted.

Next, the components housed in the package will be described. The LD 11 outputs laser light 1 with an intensity depending on the driving current. The wavelength band of the laser light 1 may be arbitrary, for example, 1310 nm band, 1550 nm band, or 1600 nm band. The LD 11 may be a Fabry-Perot semiconductor laser (FP-LD), a distributed feedback laser (DFB laser), an electroabsorption modulator integrated DFB laser (EADFB laser), a vertical external cavity surface emitting laser (VECSEL), or any other kind of semiconductor laser. The wavelength band is selected according to the specifications of the optical communication system in which the optical transmitter module 10 is employed, for example.

As shown in FIG. 3, a semiconductor optical amplifier integrated LD 31 in which the LD 32 and the semiconductor optical amplifier (SOA) 33 are integrated may be employed as the light-emitting element according to the present embodiment. The semiconductor optical amplifier integrated LD 31 may have a structure in which the semiconductor optical amplifier 33 is monolithically integrated as a single optical device, or may have a structure in which the semiconductor optical amplifier 33 is hybrid integrated.

After being generated by the LD 32, the laser light 1 enters the semiconductor optical amplifier 33, is amplified, and then exits toward the lens 12. As will be described later, since the PD 13 is located further downstream, it can receive a part of the amplified laser light 1. That is, this enables monitoring that is not possible with conventional configurations that monitor the leakage light from the source of the laser light (i.e., the laser light emitted in a direction other than the direction toward the lens 12).

The lens 12 is provided in the optical path 2 of the laser light 1. The focal point of the lens 12 on the LD 11 side is located at or near the end surface 11a of the LD 11 from which the laser light 1 is emitted. Therefore, the laser light 1 after passing through the lens 12 becomes parallel light or convergent light close to it. The focal length of the lens 12 is, for example, 1 mm.

As shown in FIG. 2, the lens 12 has an incident surface (a first surface) 12a and an exit surface (a second surface) 12b. The incident surface 12a faces the LD 11. On the other hand, the exit surface 12b faces the transparent plate 19 of the cap 16. The laser light 1 enters from the incident surface 12a and exits from the exit surface 12b.

In order to increase the intensity of the laser light 1 to be input to the optical fiber 21, it is necessary to reduce the optical connection loss in the optical transmitter module 10. In this regard, it is advantageous to use a lens having a large numerical aperture (NA) to reduce the optical connection loss.

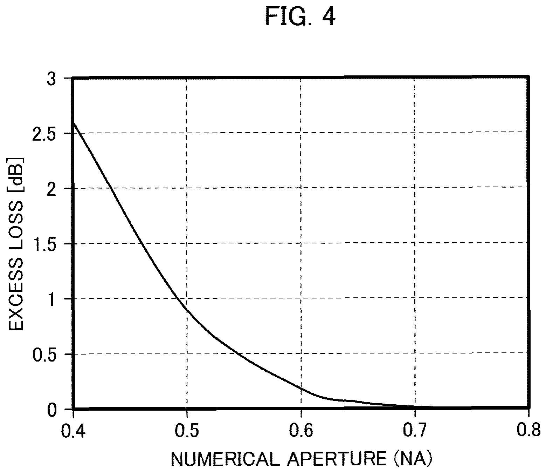

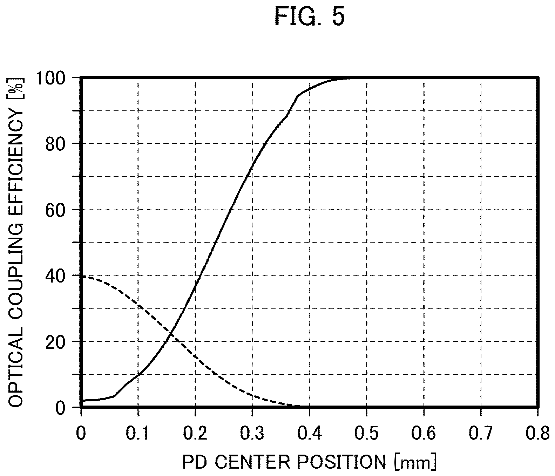

FIG. 4 is a graph showing an example of the relationship between the numerical aperture of the lens 12 and the optical coupling efficiency to the optical fiber 21. The horizontal axis indicates the numerical aperture, and the vertical axis indicates the excess loss. The laser light 1 is emitted from the LD 11 with a divergence angle. This divergence angle is, for example, 30 degrees. On the other hand, the lens 12 is required to convert the laser light 1 with such a relatively wide divergence angle into parallel or converged light. As shown in FIG. 4, the larger the numerical aperture, the smaller the excess loss, and when the numerical aperture is 0.7 or more, the excess loss is approximately 0dB. Therefore, the lens 12 according to the present embodiment has an effective aperture of 0.5 or more and less than 1. As shown in FIG. 5, the numerical aperture is preferably 0.7 or more.

The PD 13 is provided downstream of the lens 12 in the optical path 2 of the laser light 1. The PD 13 is arranged so as to partially block the optical path 2 of the laser light 1, and receives a part of the laser light 1 that has passed through the lens 12. The PD 13 converts the laser light 1 incident on a light receiving surface 13a into an electric signal corresponding to its intensity, and outputs it to a control circuit such as a feedback circuit. On the other hand, the laser light 1 that is not blocked by the PD 13 propagates directly toward the transparent plate 19.

The size (dimension) of the PD 13 is approximately equal to or smaller than the beam diameter of the laser light 1 that has passed through the lens 12. For example, the size of the PD 13 is 0.49 mm square, and the diameter of the light receiving surface 13a is 0.3 mm.

The light receiving surface 13a may be inclined with respect to the optical path 2. The inclination angle with respect to the optical path 2 is arbitrary as long as the intensity of the laser light 1 required by the optical communication system can be obtained and a signal with the intensity required for feedback control can be obtained from the PD 13. Such an inclination angle is, for example, 45 degrees. The inclination of the light receiving surface 13a increases the area within the light receiving surface 13a on which the laser light 1 is incident, while reducing the laser light 1 blocked by the PD 13. Therefore, the intensity of the laser light 1 passing through the PD 13 can be increased while increasing the output signal from the PD 13.

In order to receive a part of the laser light 1, the light receiving surface 13a of the PD 13 is shifted by a predetermined distance in a direction orthogonal to the optical axis 3 of the laser light 1 with respect to the optical axis 3. The deviation amount of the PD 13 from the optical axis 3 is set in consideration of the diameter of the optical path 2, the size and shape of the light receiving surface 13a, the intensity of the laser light 1 received by the PD 13 for the feedback control of the LD 11, and the intensity of the laser light 1 to be incident on the optical fiber 21.

FIG. 5 is a graph showing changes in optical coupling efficiency obtained by numerical analysis. The horizontal axis indicates the deviation amount of the center of the PD 13 (light receiving surface 13a) from the optical axis 3. The deviation direction of the light receiving surface 13a is orthogonal to the optical axis 3. The vertical axis indicates the optical coupling efficiency. The solid line in the figure indicates an optical coupling efficiency to the optical fiber 21, and the dotted line indicates an optical coupling efficiency to the PD 13. The conditions assumed in this numerical analysis are as follows: the divergence angle of the laser light 1 output from the LD 11 is 30 degrees (full width at half maximum), the focal length of the lens 12 is 0.45 mm, the size of the PD 13 is 0.49 mm square, the diameter of the light receiving surface 13a is 0.3 mm, and the inclination angle of the light receiving surface 13a with respect to the optical axis 3 is 45 degrees.

By performing numerical analysis as shown in FIG. 5, optical design can be achieved that matches the optical intensity required by the optical communication system. For example, when the coupling coefficient to the optical fiber 21 required by the optical communication system is 70% or more, according to the example of the analysis result shown in FIG. 5, it is preferable to set the above deviation amount to 0.3 mm or more. The upper limit of the deviation amount is appropriately set according to the light receiving sensitivity of the PD 13 and the sensitivity of the control circuit such as the feedback circuit.

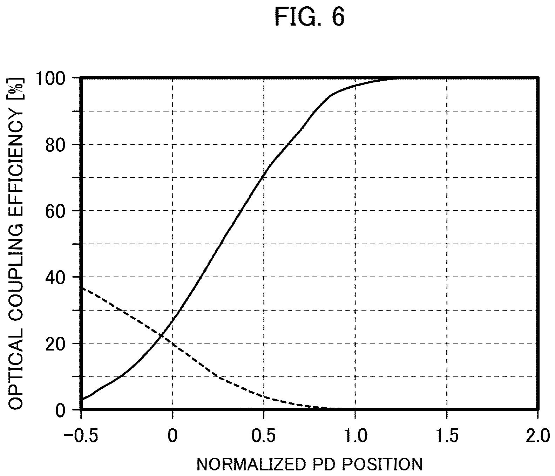

FIG. 6 is also a graph showing changes in optical coupling efficiency obtained by numerical analysis. However, the horizontal axis indicates the normalized position of the PD 13 (for convenience, referred to as normalized PD position) instead of the deviation amount of the PD 13. The normalized PD position is a value obtained by dividing the distance dx (see FIG. 2) between the optical axis 3 and the end of the PD 13 closest to the optical axis 3 by the Gaussian beam radius (i.e., $1/e^2$ half-width), assuming that the laser light 1 is a Gaussian beam. As in FIG. 5, the solid line in the figure indicates the optical coupling efficiency to the optical fiber 21, and the dotted line indicates the optical coupling efficiency to the PD 13. As shown in FIG. 6, as the value of the normalized PD position becomes smaller, the area that blocks the laser light 1 increases. Therefore, as the value of the normalized PD position becomes smaller, the optical coupling efficiency to the PD 13 increases, while the optical coupling efficiency to the optical fiber 21 decreases. It can be seen from FIG. 6 that it is preferable to set the normalized PD position to 0.5 or more when the coupling coefficient to the optical fiber 21 required by the optical communication system is 70% or more.

Assuming that the PD is arranged between the LD and the lens, the focal length of the lens needs to be sufficiently longer than the size of the PD, and is about 2 mm or more. When the numerical aperture of the lens is 0.7 and the focal length is 2 mm, the diameter of the lens (i.e., effective aperture) reaches 4 mm or more for the optical aperture alone, and it is impossible to fit within the TO-CAN package. Furthermore, the focal length of the condenser lens for coupling to the optical fiber is required to be longer in proportion to the focal length of the lens. As a result, the entire size of the module including the optical fiber 21 becomes larger in proportion to the focal length of the lens.

On the other hand, the focal length of the lens 12 according to the present embodiment is at most about 1 mm, and the numerical aperture of the lens 12 is 0.5 or more and less than 1 (preferably 0.7). Therefore, the lens 12 has a size that can be incorporated in the optical transmitter module 10, and it is possible to miniaturize the optical transmitter module 10 incorporating the PD 13.

The PD 13 in the optical transmitter module 10 is provided on the downstream side of the lens 12 in the optical path 2. The beam diameter of the laser light 1 passing through the lens 12 is sufficiently wide, and the laser light 1 is also parallel light or convergent light close to parallel light. Therefore, the position adjustment (e.g., setting the deviation amount or setting the distance with the lens 12) of the PD 13 to receive a part of the laser light 1 is also easy. That is, it is possible to easily avoid the PD 13 from physically interfering with the LD 11 and the lens 12.

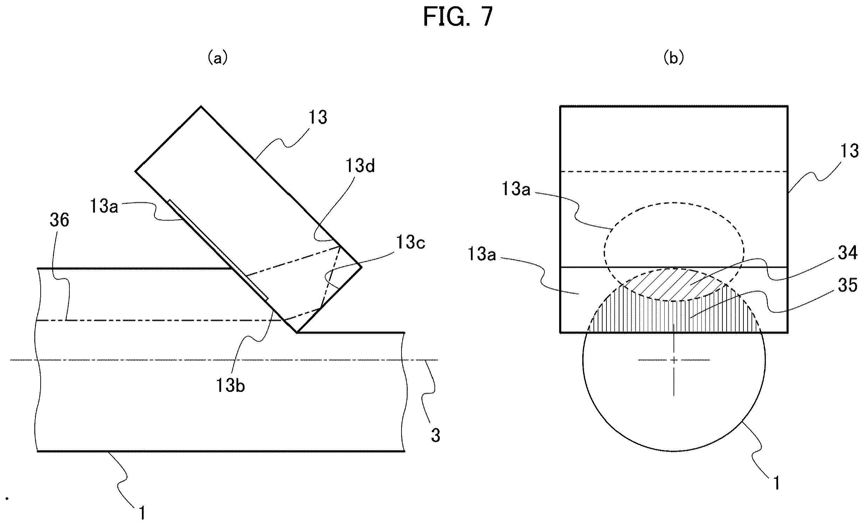

FIG. 7 is an enlarged diagram illustrating the vicinity of the PD 13 exemplified in FIG. 2, wherein (a) is a side view and (b) is a plan view viewed from the lens 20 side. The area 34 indicated by hatching lines indicates a portion of the laser light 1 that has passed through the lens 12 and overlaps with the light receiving surface 13a of the PD 13. Therefore, the laser light 1 incident on this area 34 becomes the monitor output of the PD 13.

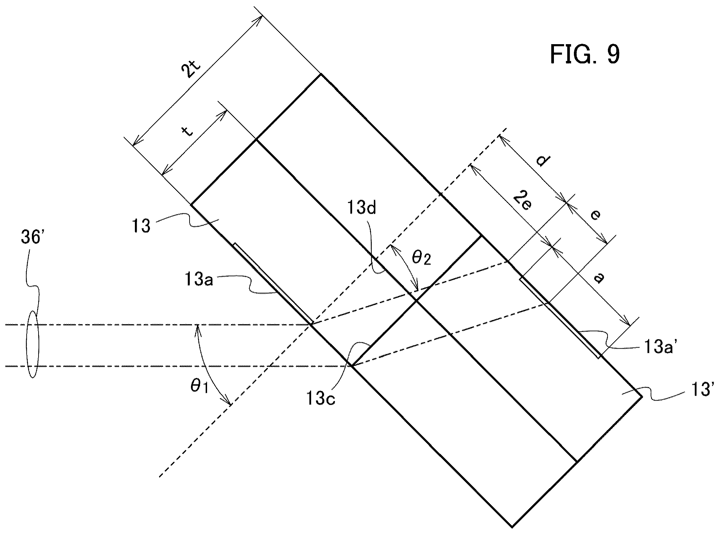

The PD 13 according to the present embodiment may have sensitivity to the laser light 1 incident on the non-light receiving surface provided on the outer periphery of the light receiving surface 13a of the laser light 1. The PD 13 is, for example, a chip having a rectangular cross section having a thickness t (see FIG. 9). In this case, the PD 13 includes a light receiving surface 13a located on the front surface, a transmission surface 13b serving as a non-light receiving surface, a reflecting surface (first reflecting surface) 13c, and a reflecting surface (second reflecting surface) 13d.

The transmission surface 13b is provided on at least a part of a surface provided with the light receiving surface 13a, and transmits the laser light 1 incident on the transmission surface 13b into the PD 13. The transmission surface 13b is parallel to the light receiving surface 13a. The transmission surface 13b may be located on the same plane as the light receiving surface 13a, or may be displaced in the thickness direction of the chip. This "transmission" is not limited to the case where the incident laser light 1 passes through the transmission surface 13b with an intensity of 100%, but includes the case where the light with a part of the intensity is reflected by the transmission surface 13b.

The reflecting surface 13c is one of the side surfaces of the PD 13, and reflects the laser light 1, which has been transmitted through the transmission surface 13b, inside the PD 13. The reflecting surface 13c is provided on the side surface of the PD 13 orthogonal to, for example, the surface on which the light receiving surface 13a is provided (i.e., the front surface).

The reflecting surface 13d reflects the laser light 1, which has been reflected by the reflecting surface 13c, toward the light receiving surface 13a inside the PD 13. The reflecting surface 13d may be on the side surface (i.e., the back surface) opposite to the surface on which the light receiving surface 13a is provided (i.e., the front surface), or may be provided between the front surface and the back surface.

The area 35 indicated by the vertical line hatching indicates the portion of the laser light 1 that has passed through the lens 12 that overlaps with the portion of the PD 13 other than the light receiving surface 13a. Conventionally, the laser light in this area contributes to neither a monitor output nor a signal output of the PD. Since it is necessary to obtain the required optical coupling efficiency of the monitor PD while also achieving high optical coupling efficiency to the optical fiber 21, the laser light in area 35 is wasted.

Therefore, in the present embodiment, the transmission surface 13b and the reflecting surfaces 13c and 13d are provided. That is, the area 35 is configured as a part of the transmission surface 13b as a non-light receiving surface. At least a part of the laser light 1 passes through the transmission surface 13b and enters the PD 13. The laser light 1 propagating inside the PD 13 is incident on the reflecting surface 13c inside the PD 13 and reflected inside the PD 13. The laser light 1 reflected by the reflecting surface 13c is further reflected by the reflecting surface 13d and incident on the light receiving surface 13a. In other words, a part of the laser light in area 35, which would otherwise be wasted, is guided to the light receiving surface 13a along the optical path 36.

On the other hand, the light receiving surface 13a is sensitive to the laser light incident from the inside of the PD 13. Therefore, by providing the transmitting surface 13b and the reflecting surfaces 13c and 13d, it is possible to increase the optical coupling efficiency of the laser light 1 to the PD 13can be increased. Alternatively, compared to a PD that does not have the transmitting surface 13b and reflecting surfaces 13c and 13d, the distance dx (see FIG. 2) can be increased even with a comparable optical coupling efficiency. Therefore, it is possible to enhance the optical coupling efficiency of the laser light 1 to the optical fiber 21.

The transmitting surface 13b of the PD 13 can transmit a part of the laser light without coating its surface. However, the transmittance of the laser light 1 can be increased by applying an anti-reflection coat to the transmitting surface 13b.

If the reflecting surfaces 13c and 13d of the PD 13 satisfy the total reflection condition, the surface coating to promote internal reflection is unnecessary. Moreover, even if the reflecting surfaces 13c and 13d do not satisfy the total reflection condition, a part of the laser light 1 can be reflected. However, in this case, the reflectance of the laser light 1 can be increased by applying a reflective coat such as gold.

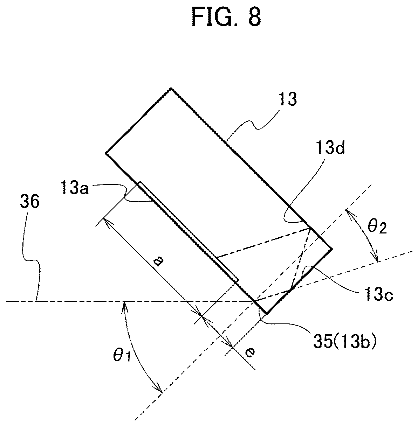

FIG. 8 is a diagram for explaining the optical path 36 of the laser light 1 incident on the transmission surface 13b. FIG. 8 is a cross-sectional view of the PD 13 including the normal direction of the light receiving surface 13a (i.e., the thickness direction of PD 13) and the direction parallel to the optical axis 3. Hereinafter, for the sake of simplicity, it is assumed that the cross-sectional shape shown in FIG. 8 continues in the direction perpendicular to the sheet of paper shown in FIG. 8. In other words, this corresponds to the case where the light receiving surface 13a is not a circle shown in FIG. 7 (b) but a rectangle. The definitions and relationships of the parameters are as follows. The values a, e, angle $\theta 1$, and angle $\theta 2$ indicate the values on the cross section shown in FIG. 8.

t: Thickness of the PD 13

n: Refractive index of the PD 13

a: Diameter or width of the light receiving surface 13a

e: Width of area 35 (the transmission surface 13b, non-light-receiving surface)

$\theta_1$: The incident angle of the optical path 36 (the laser light 1) on the PD 13 (the light receiving surface 13a and the transmission surface 13b) (i.e., the inclination angle of the PD 13 with respect to the optical axis 3)

$\theta_2$: The entrance angle of the optical path 36 within the PD 13 (i.e., the inclination angle of the optical path 36 with respect to the normal direction of the transmission surface 13b in the PD 13)

Generally, the optical path in the case of mirror reflection is easy to understand by considering a mirror image on a mirror plane. FIG. 9 illustrates mirror images 13' symmetrical to the reflecting surfaces 13c and 13d of the PD 13. The optical path 36' represents the optical path of the laser light 1 passing through the area 35 including its width.
The condition for the light receiving output of the PD 13 is that the optical path 36' is incident on the light receiving surface 13a' which is the mirror image of the light receiving surface 13a in the mirror image space.

Here, let d be the movement amount of the optical axis (i.e., the propagating distance of the laser light 1) when the optical path 36 makes one round trip inside the PD 13. The relationship between d and other parameters is expressed by the following equation (1).

$$d = 2t \tan \theta_2 = 2t \tan\left(\sin^{-1}\left(\frac{\sin\theta_1}{n}\right)\right) \quad \cdot\cdot\cdot(1)$$

From the positional relationship in FIG. 9, under the condition that $d+e \leq 2e$, i.e., $d \leq e$, the optical path 36' does not overlap the light receiving surface 13a'. Under the condition that $e < d < 2e$, a part of the optical path 36' overlaps the light receiving surface 13a'. Under the condition that $2e \leq d \leq e+a$, whole of the optical path 36' overlaps the light receiving surface 13a'. Under the condition that $2e+a \leq d$, the optical path 36' does not overlap the light receiving surface 13a'.

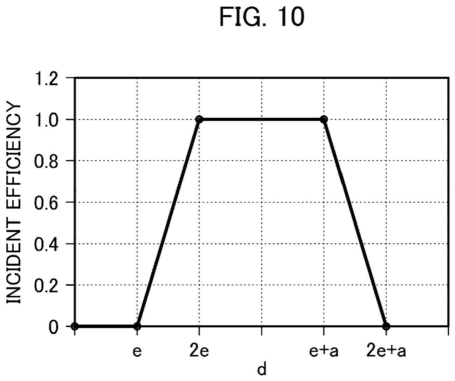

FIG. 10 is a diagram schematically showing a change in incident efficiency of the laser light 1 to the PD 13 with the movement amount d of the optical axis of the laser light 1 as a parameter. As shown in FIG. 10, in order to increase the incident efficiency of the laser light 1 to the PD 13 (i.e., the monitoring efficiency of the laser light 1 by the PD 13) and the coupling efficiency of the laser light 1 to the optical fiber 21, it is necessary to satisfy at least the following relation: $e < d < 2e+a$. When the relation of $2e \leq d \leq e+a$ is satisfied, the incident efficiency further increases.

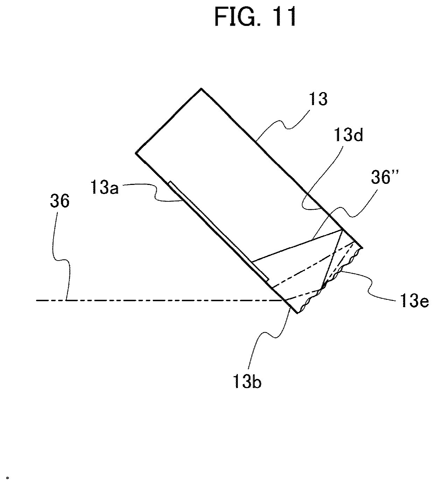

FIG. 11 is a diagram for explaining the optical path of the laser light 1 when the side surface of the PD 13 is a scattering surface. FIG. 11 shows an example where the relation $e < d$ cannot be satisfied due to the constraints of the size, refractive index, and/or arrangement of the PD 13. The PD 13 illustrated in FIG. 11 may have a scattering surface 13e as the side surface of the PD 13 instead of the reflecting surface 13c. The scattering surface 13e is a reflecting surface having minute irregularities or a surface having a function equivalent to the structure thereof, and scatters the laser light 1 inside the PD 13.

When the reflecting surface 13c shown in FIG. 8 is provided as the side surface of the PD 13 on which the laser light 1 is incident inside the PD 13, depending on the incident angle and/or the incident position of the laser light 1 with respect to the transmitting surface 13b, it may not enter the light receiving surface 13a even if it is reflected twice within the PD 13. In FIG. 11, this light is shown by a double-dashed line.

On the other hand, when the above-described side surface is the scattering surface 13e, a part of the laser light 1 incident on the scattering surface 13e inside the PD 13 is reflected at a reflection angle different from the reflection angle from that of specular reflection. Therefore, a part of the laser light 1 scattered by the scattering surface 13e can be incident on the light receiving surface 13a as shown by the optical path 36".

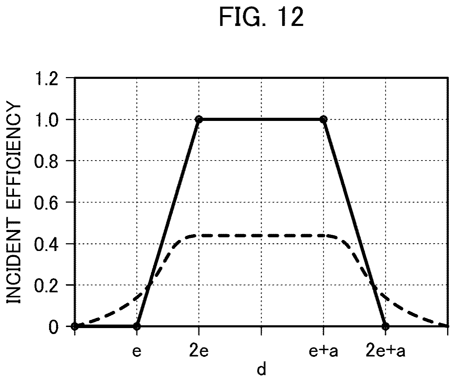

FIG. 12 is a diagram showing a change in incident efficiency when the scattering surface is provided to the light receiving element. When the scattering surface 13e exemplified in FIG. 11 is provided, the incident efficiency of the laser light 1 onto the light receiving surface 13a varies with the movement amount d of the optical axis shown in FIG. 10, as indicated by the broken line 40 in FIG. 12. In this case, regardless of the relationship between the movement amount d of the optical axis and the width e, an increase of the light receiving efficiency of the monitoring light can be expected by the internal reflection of the PD 13. In particular, when the relation $d \leq e$ is satisfied and the laser light 1 is not scattered, the light receiving efficiency of the monitoring light does not increase. Therefore, when the relation $d \leq e$ is satisfied, it is unconditionally preferable to cause the laser light 1 to scatter.

Note that the surface on which the laser light 1 is scattered is not limited to the side surface of the PD 13. That is, the transmitting surface 13b may have a structure to scatter the laser light 1, and the reflecting surface 13d may be configured as a scattering surface. In other words, at least one of the transmitting surface 13b, the reflecting surface 13c, and the reflecting surface 13d illustrated in FIG. 7 may be configured as a scattering surface.

REFERENCE SIGNS LIST

1 laser light
2 optical path
3 optical axis
10 optical transmitter module
11 laser diode (light emitting element)
12 lens
12a incident surface (first surface)
12b output surface (second surface)
13 photodiode (light receiving element)
13a light receiving surface
13b transmitting surface (non-light receiving surface)
13c reflecting surface
13d reflecting surface
13e scattering surface
14 package
15 stem
16 cap
17 lead pin
18 carrier
19 transparent plate
19a incident surface
19b exit surface
20 condenser lens
21 optical fiber
21a end
31 semiconductor optical amplifier integrated LD
32 laser diode
33 semiconductor optical amplifier

**Claims**

1. An optical transmitter module comprising:

   a light emitting element configured to output a laser light;
   a lens provided in an optical path of the laser light;
   a light receiving element provided downstream of the lens in the optical path of the laser light and configured to receive a part of the laser light that has passed through the lens.

2. The optical transmitter module according to claim 1, further comprising:
   a package configured to house the light emitting element, the lens, and the light receiving element and including a transparent plate through which the laser light passes.

3. The optical transmitter module according to claim 1 or 2, wherein
   a numerical aperture of the lens is 0.5 or more and less than 1.

4. The optical transmitter module according to claim 1 or 2, wherein
   the light receiving element includes a non-light receiving surface provided on an outer periphery of a light receiving surface of the laser light and has sensitivity to the laser light incident on the non-light receiving surface.

5. The optical transmitter module according to claim 4, wherein,

   in a cross section including a direction parallel to an optical axis of the laser light and a normal direction of the light receiving surface, the light receiving element satisfies the relation

   $$e \le d \le 2e+a,$$

   where e is a width of the non-light receiving surface in the cross section, a is a width of the light receiving surface in the cross section, and d is a movement amount of the optical axis when the laser light makes one round trip inside the light receiving element in the cross section, expressed by the following equation (1)

   $$d = 2t \tan \theta_2 = 2t \tan \left( \sin^{-1} \left( \frac{\sin \theta_1}{n} \right) \right) \qquad \cdot \cdot \cdot (1)$$
   ,

   where t is a thickness of the light receiving element, $\theta_1$ is an incident angle of the laser light to the light receiving element, and n is a refractive index of the light receiving element.

6. The optical transmitter module according to claim 5, wherein
   in the cross section including the direction parallel to the optical axis of the laser light and the normal direction of the light receiving surface, the light receiving element satisfies the relation $2e \le d \le e+a$.

7. The optical transmitter module according to claim 4, wherein

   the light receiving element includes:

   a first reflecting surface configured to reflect the laser light transmitted through the non-light receiving surface inside the light receiving element; and
   a second reflecting surface configured to reflect the laser light reflected by the first reflecting surface toward the light receiving surface inside the light receiving element; wherein

   at least one of the non-light receiving surface, the first reflecting surface, and the second reflecting surface is formed as a scattering surface configured to scatter the laser light.

FIG. 1

(a)

(b)

FIG. 2

FIG. 3

(a)

(b)

## FIG. 4

FIG. 5

FIG. 6

FIG. 7

(a)

(b)

EP 4 693 768 A1

## FIG. 8

FIG. 9

EP 4 693 768 A1

# FIG. 10

# FIG. 11

# FIG. 12

## INTERNATIONAL SEARCH REPORT

| International application No. |
|---|
| **PCT/JP2024/012995** |

**A. CLASSIFICATION OF SUBJECT MATTER**

*H01S 5/02253*(2021.01)i; *H01S 5/0239*(2021.01)i
FI:   H01S5/02253; H01S5/0239

According to International Patent Classification (IPC) or to both national classification and IPC

**B. FIELDS SEARCHED**

Minimum documentation searched (classification system followed by classification symbols)

H01S5/00-5/50, H01L31/00-31/02, 31/08-31/10, 31/18, H10K30/60-30/65, 39/30

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2021/251486 A1 (SUMITOMO ELECTRIC INDUSTRIES, LTD.) 16 December 2021 (2021-12-16)<br>paragraphs [0031], [0038]-[0039], [0041], [0062], fig. 3-5 | 1-3 |
| Y | | 4-6 |
| A | | 7 |
| Y | JP 2-502585 A (BT & D TECHNOLOGIES LTD.) 16 August 1990 (1990-08-16)<br>p. 3, upper left column, lines 12-15, fig. 2 | 4-6 |
| Y | WO 2021/166215 A1 (MITSUBISHI ELECTRIC CORPORATION) 26 August 2021 (2021-08-26)<br>paragraph [0013], fig. 1 | 5-6 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 May 2024** | **11 June 2024** |

| Name and mailing address of the ISA/JP | Authorized officer |
|---|---|
| **Japan Patent Office (ISA/JP)**<br>3-4-3 Kasumigaseki, Chiyoda-ku, Tokyo 100-8915<br>Japan | |
| | Telephone No. |

Form PCT/ISA/210 (second sheet) (July 2022)

### INTERNATIONAL SEARCH REPORT
**Information on patent family members**

International application No.

**PCT/JP2024/012995**

| Patent document cited in search report | | | Publication date (day/month/year) | Patent family member(s) | | | Publication date (day/month/year) |
|---|---|---|---|---|---|---|---|
| WO | 2021/251486 | A1 | 16 December 2021 | US | 2022/0416901 | A1 | |
| | | | | paragraphs [0045], [0052]-[0053], [0055], [0076], fig. 3-5 | | | |
| | | | | CN | 115698801 | A | |
| | | | | TW | 202212886 | A | |
| JP | 2-502585 | A | 16 August 1990 | US | 4983009 | A | |
| | | | | column 3, line 67 to column 4, line 4, fig. 2 | | | |
| | | | | WO | 89/05467 | A1 | |
| | | | | EP | 319230 | A1 | |
| WO | 2021/166215 | A1 | 26 August 2021 | TW | 202133517 | A | |

Form PCT/ISA/210 (patent family annex) (July 2022)

**EP 4 693 768 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004165299 A